# EUROPÄISCHE PATENTSCHRIFT

(11) **EP 3 894 832 B1**
(45) Veröffentlichungstag und Bekanntmachung des Hinweises auf die Patenterteilung: **11.12.2024**
(21) Anmeldenummer: 19794931.6
(22) Anmeldetag: 22.10.2019
(51) Int. Cl.: F02D 41/22, G01N 15/06, F02D 41/06, F02D 41/14

(54) **VERFAHREN ZUM BETREIBEN EINES SENSORS ZUR DETEKTION VON TEILCHEN IN EINEM MESSGAS**
METHOD FOR OPERATING A SENSOR FOR DETECTING PARTICLES IN A MEASUREMENT GAS
PROCÉDÉ POUR FAIRE FONCTIONNER UN CAPTEUR POUR LA DÉTECTION DE PARTICULES DANS UN GAZ DE MESURE

(30) Priorität: 12.12.2018 DE 102018221567
(43) Veröffentlichungstag der Anmeldung: 20.10.2021
(73) Patentinhaber: Robert Bosch GmbH, 70442 Stuttgart (DE)
(72) Erfinder: SCHILLING, Carolin Maria, 76669 Bad Schoenborn (DE)
(86) Internationale Anmeldenummer: PCT/EP2019/078670
(87) Internationale Veröffentlichungsnummer: WO 2020/119985

(56) Entgegenhaltungen:
- EP-A2- 1 898 205
- DE-A1- 102010 011 635
- DE-A1- 102011 006 923
- DE-A1- 102011 086 148
- DE-A1- 102015 215 848
- US-A1- 2011 107 815
- US-A1- 2012 031 168
- US-A1- 2018 313 739

## Beschreibung

### Stand der Technik

Aus dem Stand der Technik sind zahlreiche Verfahren und Vorrichtungen zur Detektion von Teilchen, wie beispielsweise Ruß- oder Staubpartikeln, bekannt.

Die Erfindung wird im Folgenden, ohne Beschränkung weiterer Ausführungsformen und -anwendungen, insbesondere unter Bezugnahme auf Sensoren zur Detektion von Teilchen, insbesondere von Rußpartikeln in einem Abgasstrom einer Brennkraftmaschine, beschrieben.

Es ist aus der Praxis bekannt, mittels zwei Elektroden, die auf einer Keramik angeordnet sind, eine Konzentration von Teilchen, wie beispielsweise Ruß- oder Staubpartikeln, in einem Abgas zu messen. Dies kann beispielsweise durch eine Messung des elektrischen Widerstands des die beiden Elektroden trennenden keramischen Werkstoffs erfolgen. Genauer wird der elektrische Strom gemessen, der beim Anlegen einer elektrischen Spannung an die Elektroden zwischen diesen fließt. Die Rußpartikel lagern sich aufgrund elektrostatischer Kräfte zwischen den Elektroden ab und bilden mit der Zeit elektrisch leitfähige Brücken zwischen den Elektroden. Je mehr dieser Brücken vorhanden sind, umso mehr steigt der gemessene Strom. Es bildet sich somit ein zunehmender Kurzschluss der Elektroden. Das Sensorelement wird periodisch regeneriert, in dem er durch ein integriertes Heizelement auf mindestens 700°C gebracht wird, wodurch die Rußablagerungen wegbrennen.

Derartige Sensoren werden beispielsweise in einem Abgasstrang einer Brennkraftmaschine, wie beispielsweise einem Verbrennungsmotor der Dieselbauart eingesetzt. Üblicherweise befinden sich diese Sensoren stromabwärts des Auslassventils bzw. des Rußpartikelfilters.

Trotz der zahlreichen Vorteile der aus dem Stand der Technik bekannten Vorrichtungen zur Detektion von Teilchen beinhalten diese noch Verbesserungspotenzial. Das keramische Sensorelement ist empfindlich gegenüber ankommender Feuchte bzw. anfällig für hydrothermale Alterung. Verschiedenste Schädigungsmechanismen am Sensorelement durch Wasser oder Kondensat sind bekannt und eine zuverlässige Erkennung der Trocknung der Elektroden bisher nicht möglich.

Derartige Sensoren und zugehörige Betriebsverfahren sind beispielsweise bekannt aus der DE 10 2011 086 148 A1, der EP 1 898 205 A2, der US 2018/313 739 A1, der US 2011/107 815 A1, der US 2012/031 168 A1 und der DE 10 2015 215 848 A1.

### Offenbarung der Erfindung

Es wird daher gemäß Anspruch 1 ein Verfahren zum Betreiben eines Sensors zur Detektion von Teilchen, insbesondere von Rußpartikeln vorgeschlagen, welches die Nachteile bekannter Betriebsverfahren zumindest weitgehend vermeidet und insbesondere die Erkennung von Feuchtigkeit im Elektroden-Bereich erlaubt und nicht allein von der Taupunktendebedatung abhängig zu sein, um auf Feuchte im Sensorelement zu schließen.

Bei einem erfindungsgemäßen Verfahren zum Betreiben eines Sensors zur Detektion von Teilchen, insbesondere von Rußpartikeln, in einem Messgas, insbesondere im Abgas einer Brennkraftmaschine, wobei der Sensor ein Sensorelement aufweist, wobei das Sensorelement mindestens ein elektrisch isolierendes Element Substrat, eine erste Elektrode und eine zweite Elektrode aufweist, wobei die erste Elektrode und die zweite Elektrode an dem elektrisch isolierenden Element angeordnet sind, führen die erste Elektrode und die zweite Elektrode eine Strom- und/oder Spannungsmessung durch. Der Sensor wird in mindestens einer Messphase betrieben. Während der Messphase wird an die erste Elektrode und die zweite Elektrode eine erste elektrische Spannung angelegt. Während eines vorbestimmten Zeitraums außerhalb der Messphase wird an die erste Elektrode und die zweite Elektrode eine zweite elektrische Spannung angelegt. Die zweite elektrische Spannung ist kleiner als eine Zersetzungsspannung für Wasser (1,23 V). Dabei wird auf das Vorhandensein von Wasser auf dem Sensorelement geschlossen, falls die Strom- und/oder Spannungsmessung bei angelegter zweiter elektrischer Spannung einen Wert ergibt, der einen Schwellwert für einen elektrischen Strom überschreitet.

Die hier vorgeschlagene Betriebsstrategie ermöglicht es, Feuchte, welche die Elektroden kurzschließt, zu erkennen und somit eine Regeneration oder das Einschalten der Messspannung zu verhindern. Sowohl Feuchte während der Regeneration als auch das Anlegen der Messspannung am feuchten Sensorelement würden das Sensorelement schädigen. Abplatzer und Platinversprödung wären die Folge. Insbesondere erlaubt das Verfahren die Bestimmung von Feuchte immer dann, wenn der Sensor nicht zur Partikelmessung verwendet wird. Das Verfahren dient somit unter anderem zur aktiven Feuchtebestimmung an einem Sensor zur Partikelmessung.

Bei einer Weiterbildung wird eine Regeneration des Sensors oder ein Wechsel in die Messphase verhindert, falls die Strom- und/oder Spannungsmessung bei angelegter zweiter elektrischer Spannung einen Wert ergibt, der einen ersten Schwellwert für einen elektrischen Strom überschreitet. Wird durch die vergleichsweise geringe zweite elektrische Spannung ein elektrischer Strom gemessen, ist klar, dass der Sensor durch Feuchte benetzt ist, und zum Schutz des Sensorelementes wird eine Regeneration oder Messphase verhindert bzw. blockiert.

Bei einer Weiterbildung wird eine Regeneration des Sensors oder ein Wechsel in die Messphase freigegeben, falls der Wert der Strom- und/oder Spannungsmessung nach dem Überschreiten des ersten Schwellwerts einen zweiten Schwellwert für einen elektrischen Strom unterschreitet. Der erste Schwellwert und der zweite Schwellwert können sich voneinander unterscheiden oder identisch sein. Wird durch die vergleichsweise geringe zweite elektrische Spannung ein elektrischer Strom gemessen, ist klar, dass der Sensor durch Feuchte benetzt ist, und zum Schutz des Sensorelementes wird eine Regeneration oder Messphase nur nach einem Rückgang des Stromes an den Elektroden. So können die Elektroden zusätzlich geschützt werden. Durch das Anlegen dieser sehr geringen Spannung an die Elektroden wird verhindert, dass durch Elektrolyse die Elektroden geschädigt werden, und so werden die Elektroden aktiv geschützt.

Bei einer Weiterbildung wird eine Regeneration des Sensors oder ein Wechsel in die Messphase nach einer vorbestimmten Zeit nach einem Unterschreiten des zweiten Schwellwerts freigegeben. Eine Abwandlung des Verfahrens sieht somit vor, nach Abklingen eines Stromes an den Elektroden durch Feuchte noch eine gewisse Zeit zu warten, um Feuchte aus den tieferen Keramikschichten des Sensorelements auch sicher ausgetragen zu haben, bevor das Sensorelement regeneriert oder mit Messspannung beschalten wird.

Bei einer Weiterbildung wird eine Regeneration des Sensors oder ein Wechsel in die Messphase freigegeben, falls der Sensor von extern, bevorzugt einem Steuergerät, eine Taupunktendefreigabe erhält. Somit erfolgt die Freigabe für eine Regeneration des Sensors oder ein Wechsel in die Messphase nur, falls keine Feuchte am Sensorelement (mehr) erfasst wird und zusätzlich eine Taupunktendefreigabe vorliegt.

Bei einer Weiterbildung der Sensor während des vorbestimmten Zeitraums außerhalb der Messphase beheizt wird. Diese Heizen wird auch als Schutzheizen bezeichnet. Somit wird zum Schutz des keramischen Sensorelementes der Sensor mit einer Schutzheizstrategie betrieben, um weiteres Anlagern von Feuchte zu verhindern und um das Sensorelement zu trocknen.

Bei einer Weiterbildung wird der Sensor auf eine Temperatur beheizt, deren Höhe von dem Wert der Strom- und/oder Spannungsmessung bei angelegter zweiter elektrischer Spannung abhängt. Somit wird die Höhe des Stromes während des Anlegens der zweiten elektrischen Spannung und während des Schutzheizens ausgewertet und die Schutzheiztemperatur zur schnelleren Trocknung des Sensorelementes oder zur schonenderen Trocknung des Sensorelementes angepasst.

Bei einer Weiterbildung ist der Sensor in einem Abgastrakt einer Brennkraftmaschine angeordnet, wobei der vorbestimmte Zeitraum außerhalb der Messphase nach einem Kaltstart der Brennkraftmaschine, bei fehlender Taupunktendefreigabe durch ein Motorsteuergerät der Brennkraftmaschine und/oder bei Unterschreiten einer vorbestimmten Temperatur im Abgastrakt ist.

Eine weitere Abwandlung des Verfahrens sieht vor, die Schutzheiztemperatur stark abzusenken bis zu unbeheizt und die inaktiven Zeiten des Sensors zu nutzen, um mit 1V die Elektroden zu beschalten und anhand des dadurch fließenden Stromes Feuchtigkeit im Abgastrakt zu bestimmen und diese Zusatzinformation dem Motorsteuergerät zur Verfügung zu stellen, bzw. Taupunktende durch Messung zu bestimmen und nicht auf Modelle angewiesen zu sein.

Bei einer Weiterbildung ist die zweite elektrische Spannung einen Wert in einem Bereich von 0,005 V bis 1,2 V und bevorzugt 0,05 V bis 1,0 V.

Es wird weiterhin gemäß Anspruch 10 ein Computerprogramm umfassend Befehle vorgeschlagen, welche bewirken, dass ein mit einem Sensor zur Detektion von Partikeln verbundenes elektronisches Steuergerät jeden Schritt des erfindungsgemäßen Verfahrens durchführt.

Es wird weiterhin gemäß Anspruch 11 ein elektronisches Speichermedium vorgeschlagen, auf welchem ein solches Computerprogramm gespeichert ist.

Es wird weiterhin gemäß Anspruch 12 ein elektronisches Steuergerät vorgeschlagen, welches ein solches elektronisches Speichermedium umfasst.

Unter einem Teilchen im Sinne der vorliegenden Erfindung ist ein Partikel, insbesondere ein elektrisch leitfähiges Teilchen, zu verstehen, wie beispielsweise Ruß- oder Staubpartikel.

Unter einer Elektrode ist im Rahmen der vorliegenden Erfindung ein Bauteil zu verstehen, das für eine Strom- und/oder Spannungsmessung geeignet ist. Die Angaben erste und zweite Elektrode werden im Rahmen der vorliegenden Erfindung lediglich verwendet, um die Elektroden begrifflich zu unterscheiden, sollen aber keine bestimmte Reihenfolge oder Gewichtung dieser Bauteile angeben.

Im Rahmen der vorliegenden Erfindung können die Elektroden als Interdigitalelektroden ausgebildet sein. Unter Interdigitalelektroden sind im Rahmen der vorliegenden Erfindung Elektroden zu verstehen, die so angeordnet sind, dass sie ineinander eingreifen, insbesondere kammförmig ineinander eingreifen.

Unter einer Strom- und/oder Spannungsmessung ist im Rahmen der vorliegenden Erfindung eine Messung eines elektrischen Stroms und/oder einer elektrischen Spannung zu verstehen. Die Messung erfolgt dabei zwischen zwei Elektroden bzw. einer Elektrode und einem Bezugspotential. Dabei kann an die Elektroden eine bestimmte elektrische Spannung angelegt werden und ein Stromfluss zwischen den Elektroden gemessen werden oder an die Elektroden ein elektrischer Strom angelegt werden und eine Spannung zwischen den Elektroden gemessen werden. Eine Strom- und/oder Spannungsmessung kann insbesondere eine Widerstandsmessung sein, wobei ein Widerstand des durch die Elektroden und das Substrat gebildeten Aufbaus gemessen werden kann. Es kann beispielsweise eine spannungsgesteuerte oder spannungsgeregelte Messung und/oder eine stromgesteuerte und/oder stromgeregelte Messung erfolgen. Das Anlegen des Stroms und/oder der elektrischen Spannung kann in Form eines kontinuierlichen Signals und/oder auch in Form eines gepulsten Signals erfolgen. So kann beispielsweise eine Gleichspannung und/oder ein Gleichstrom angelegt werden und eine Stromantwort bzw. eine Spannungsantwort erfasst werden. Alternativ kann eine gepulste Spannung und/oder ein gepulster Strom angelegt werden und eine Stromantwort bzw. eine Spannungsantwort erfasst werden. Statt des momentanen Stromflusses durch die Elektroden kann auch ein Widerstand der Elektroden bzw. dessen Kehrwert (=Leitwert) als Messgröße verwendet werden. Auch kann es sinnvoll sein, aus einem momentanen Stromfluss eine Ladungsmenge zu integrieren. Weiterhin ist es möglich eine Hochspannung an eine Elektrode anzulegen und an einer Gegenelektrode oder einer elektrischen Masse einen elektrischen Strom, wie beispielsweise einem Entladestrom, zu messen.

Unter einer Messphase ist im Rahmen der vorliegenden Erfindung ein Zeitraum zu verstehen, in dem eine an die Elektroden angelegte Spannung oder Spannungsform derart gewählt ist, dass sie eine möglichst genaue Bestimmung des Widerstandes beziehungsweise der Impedanz und somit der Partikelbeladung des Sensors ermöglicht. Die Spannung während der Messphase muss dabei nicht für das Sammeln von Partikeln aus dem Messgas geeignet oder optimiert sein.

Unter einem Substrat ist im Rahmen der vorliegenden Erfindung ein Gegenstand mit einer plattenförmigen, würfelförmigen, quaderförmigen oder jeglichen anderen geometrischen Ausbildung zu verstehen, der mindestens eine ebene Oberfläche aufweist und aus einem keramischen Material, metallischen Material, Halbleitermaterial oder Kombinationen derselben hergestellt ist.

Unter einer Zersetzungsspannung für Wasser ist im Rahmen der vorliegenden Erfindung die zur Durchführung einer Elektrolyse von Wasser mindestens benötigte Differenz der Elektrodenpotentiale von Anode und Kathode zu verstehen. Bei dieser Spannung beginnt die Zersetzung des Elektrolyten durch elektrische Anziehungskräfte, die zwischen den Elektroden einerseits und den jeweils entgegengesetzt geladenen Anionen bzw. Kationen andererseits wirken. Elektrolyse nennt man einen Prozess, bei dem elektrischer Strom eine Redoxreaktion erzwingt. Eine Elektrolyse erfordert eine Gleichspannungsquelle, welche die elektrische Energie liefert und die chemischen Umsetzungen vorantreibt. Ein Teil der elektrischen Energie wird in chemische Energie umgewandelt. Für Wasser ist die Zersetzungsspannung im Rahmen der vorliegenden Erfindung 1,23 V.

Ein Grundgedanke der vorliegenden Erfindung ist, eine Spannung unterhalb der Zersetzungsspannung von Wasser an die Elektroden während des Schutzheizens anzulegen, um durch den Kurzschluss durch Wasser auf den Elektroden Feuchte zu erkennen. Wird durch diese geringe Spannung ein elektrischer Strom gemessen, ist klar, dass der Sensor durch Feuchte benetzt ist, und zum Schutz des Sensorelementes wird eine Regeneration oder Messphase nur freigegeben nach Taupunktfreigabe und Rückgang des Stromes an den Elektroden. So können die Elektroden zusätzlich geschützt werden. Durch das Anlegen dieser sehr geringen Spannung an die Elektroden wird verhindert, dass durch Elektrolyse die Elektroden geschädigt werden, und so werden die Elektroden aktiv geschützt.

### Kurze Beschreibung der Zeichnungen

Weitere optionale Einzelheiten und Merkmale der Erfindung ergeben sich aus der nachfolgenden Beschreibung bevorzugter Ausführungsbeispiele, welche in den Figuren schematisch dargestellt sind.

Es zeigen:
Figur 1 eine Draufsicht auf einen Sensor zur Detektion von Teilchen gemäß einer Ausführungsform der vorliegenden Erfindung und
Figur 2 ein Flussdiagramm eines Verfahrens zum Betreiben eines Sensors zur Detektion von Teilchen gemäß einer Ausführungsform der vorliegenden Erfindung.

### Ausführungsformen der Erfindung

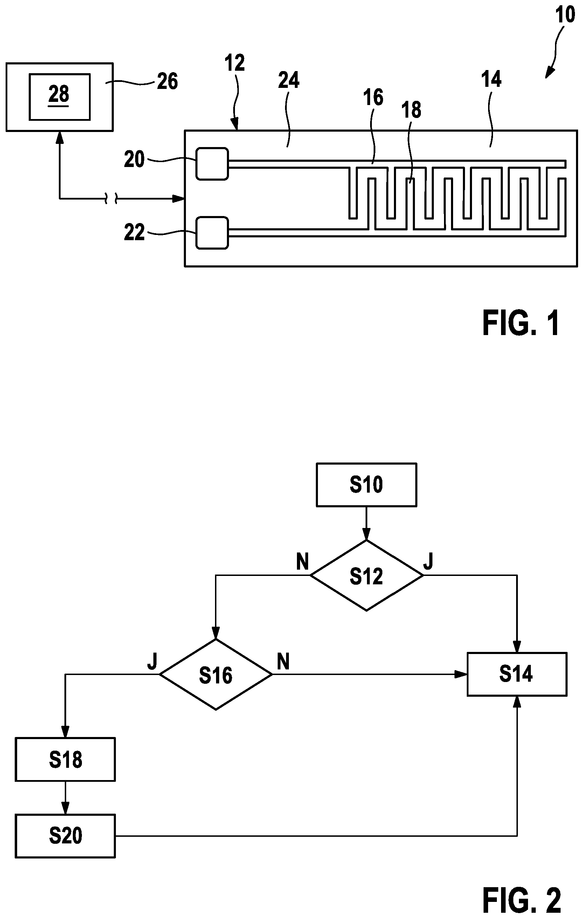

Figur 1 zeigt eine Draufsicht auf einen Sensor 10 zur Detektion von Teilchen in einem Messgas gemäß einer Ausführungsform der vorliegenden Erfindung. Der Sensor 10 ist insbesondere zur Detektion von Rußpartikeln in einem Gasstrom, wie beispielsweise einem Abgasstrom, einer Brennkraftmaschine und zum Einbau in einem Abgasstrang eines Kraftfahrzeugs ausgebildet. Beispielsweise ist der Sensor 10 als Rußsensor ausgebildet und lässt sich stromabwärts oder stromaufwärts eines Rußpartikelfilters eines Kraftfahrzeugs mit einem Dieselverbrennungsmotor anordnen. Bei dem gezeigten Beispiel handelt es sich bei dem Messgas um Abgas einer Brennkraftmaschine. Der Sensor 10 ist bei dem gezeigten Ausführungsbeispiel als resistiver Partikelsensor ausgebildet.

Der Sensor 10 umfasst ein Sensorelement 12. Das Sensorelement 12 umfasst ein elektrisch isolierendes Element 14. Das elektrisch isolierende Element 14 ist ein Substrat. Das Substrat ist beispielsweise ein Siliziumwafer. Alternativ ist das Substrat aus einem keramischen Material hergestellt. Das elektrisch isolierende Element 14 ist im Wesentlichen quaderförmig ausgebildet. Das Sensorelement 10 umfasst weiterhin eine erste Elektrode 16, eine zweite Elektrode 18, eine erste Zuleitung 20 und eine zweite Zuleitung 22. Die erste Elektrode 16, die zweite Elektrode 18, die erste Zuleitung 20 und die zweite Zuleitung 22 sind auf einer Oberseite 24 des Substrats 14 angeordnet. Die erste Elektrode 16 und die zweite Elektrode 18 sind als Interdigitalelektroden ausgebildet. Die erste Elektrode 16 ist mit der ersten Zuleitung 20 verbunden. Die zweite Elektrode 18 ist mit der zweiten Zuleitung 22 verbunden. Die erste Zuleitung 20 und die zweite Zuleitung 22 stellen Anschlusskontakte dar, die zum elektrischen Kontaktieren der ersten Elektrode 16 und der zweiten Elektrode 18 ausgebildet sind. Die erste Elektrode 16 und die zweite Elektrode 18 sind zum Durchführen einer Strom- und/oder Spannungsmessung ausgebildet. Der Sensor 10 kann optional weitere Bauteile aufweisen, wie beispielsweise ein Schutzrohr und/oder ein Heizelement, die nicht näher dargestellt sind. Der Sensor wird in mindestens einer Messphase betrieben. Während der Messphase wird an die erste Elektrode 16 und die zweite Elektrode 18 eine erste elektrische Spannung von beispielsweise 45 V angelegt,

Der Sensor 10 ist mit einem elektronischen Steuergerät 26 verbunden. Das elektronische Steuergerät 26 ist beispielsweise ein Motorsteuergerät der Brennkraftmaschine. Das elektronische Steuergerät weist ein elektronisches Speichermedium 28, wie beispielsweise einen Chip, auf, auf dem ein Computerprogramm gespeichert ist. Das Computerprogramm enthält Anweisungen zum Durchführen eines Verfahrens zum Betreiben des Sensors 10. Ein solches Verfahren wird nachstehend ausführlicher beschrieben.

Figur 2 zeigt ein Flussdiagramm eines Verfahrens zum Betreiben eines Sensors 10 zur Detektion von Teilchen gemäß einer Ausführungsform der vorliegenden Erfindung, wie beispielsweise des in Figur 1 dargestellten Sensors 10. In Schritt S10 wird die Brennkraftmaschine gestartet. In Schritt S12 wird geprüft, ob sich der Sensor 10 sich in einem Zeitraum außerhalb der Messphase befindet. Um den Zeitraum außerhalb der Messphase handelt es sich beispielsweise bei einem Kaltstart der Brennkraftmaschine, fehlender Taupunktendefreigabe durch ein Motorsteuergerät der Brennkraftmaschine und/oder bei Unterschreiten einer vorbestimmten Temperatur im Abgastrakt. Ergibt die Prüfung in Schritt S12, dass es sich nicht um einen Kaltstart handelt, eine Taupunktendefreigabe vorliegt und/oder die vorbestimmte Temperatur im Abgastrakt überschritten ist, kann das Vorhandensein von Feuchte an dem Sensorelement 12 ausgeschlossen werden. In diesem Fall schreitet das Verfahren zu Schritt S14 fort, bei dem in die Messphase gewechselt wird.

Ergibt die Prüfung in Schritt S12, dass es sich um einen Kaltstart handelt, eine Taupunktendefreigabe nicht vorliegt und/oder die vorbestimmte Temperatur im Abgastrakt unterschritten ist, wird ein vorbestimmter Zeitraum außerhalb der Messphase bestimmt und das Verfahren schreitet zu Schritt S16 fort. In Schritt S16 wird während des vorbestimmten Zeitraums außerhalb der Messphase an die erste Elektrode 16 und die zweite Elektrode 18 eine zweite elektrische Spannung angelegt, wobei die zweite elektrische Spannung kleiner als eine Zersetzungsspannung für Wasser ist. Die zweite elektrische Spannung ist ein Wert in einem Bereich von 0,005 V bis 1,2 V und bevorzugt 0,05 V bis 1,0 V, beispielsweise 0,8 V oder 1,0 V. Zusätzlich zu potentiellen Freigaben von außerhalb des Sensors 10, erfolgt eine eigene Überprüfung des Sensors 10 auf mögliches Vorhandensein von Wasser auf dem Sensorelement12. Der Sensor 10 wird während des vorbestimmten Zeitraums außerhalb der Messphase beheizt. Falls die Strom- und/oder Spannungsmessung bei angelegter zweiter elektrischer Spannung einen Wert ergibt, der einen Schwellwert für einen elektrischen Strom überschreitet, wird auf das Vorhandensein von Wasser auf dem Sensorelement 12 geschlossen. Der erste Schwellwert ist beispielsweise 0 A. Falls die Strom- und/oder Spannungsmessung bei angelegter zweiter elektrischer Spannung in Schritt S16 einen Wert ergibt, der einen ersten Schwellwert für einen elektrischen Strom überschreitet, schreitet das Verfahren zu Schritt S18 fort und eine Regeneration des Sensors 10 oder ein Wechsel in die Messphase wird verhindert. Wird der erste Schwellwert nicht überschritten, kann Wasser bzw. Feuchte ausgeschlossen werden und das Verfahren schreitet zu Schritt S14 fort und es wird in die Messphase gewechselt. Im Anschluss an Schritt S18 folgt Schritt S20, bei dem eine Regeneration des Sensors oder ein Wechsel in die Messphase freigegeben wird, falls der Wert der Strom- und/oder Spannungsmessung nach dem Überschreiten des ersten Schwellwerts einen zweiten Schwellwert für einen elektrischen Strom unterschreitet. Der zweite Schwellwert kann identisch zu dem ersten Schwellwert sein oder sich davon unterscheiden. Somit erfolgt die Freigabe erst nach Rückgang des Stromes an den Elektroden 16, 18. Das Verfahren schreitet dann zu Schritt S14 fort und es wird in die Messphase gewechselt.

Das Verfahren kann wie folgt modifiziert werden. Eine Regeneration des Sensors 10 oder ein Wechsel in die Messphase wird nach einer vorbestimmten Zeit nach einem Unterschreiten des zweiten Schwellwerts freigegeben. Mit anderen Worten wird nach Abklingen eines Stromes an den Elektroden durch Feuchte noch eine gewisse Zeit gewartet, um Feuchte aus den tieferen Keramikschichten des Sensorelements 12 auch sicher ausgetragen zu haben, bevor das Sensorelement 12 regeneriert oder mit Messspannung beschalten wird. Eine Regeneration des Sensors 10 oder ein Wechsel in die Messphase wird freigegeben, falls zusätzlich zu dem Rückgang des Stroms an den Elektroden 16, 18 der Sensor 10 von extern, wie beispielsweise dem Steuergerät 26, eine Taupunktendefreigabe erhält. Der Sensor wird auf eine Temperatur beheizt, deren Höhe von dem Wert der Strom- und/oder Spannungsmessung bei angelegter zweiter elektrischer Spannung abhängt. Mit anderen Worten wird die Höhe des Stroms durch die Beschaltung mit der zweiten elektrischen Spannung während des Schutzheizens ausgewertet, um die Schutzheiztemperatur zur schnelleren Trocknung des Sensorelementes oder zur schonenderen Trocknung des Sensorelementes anzupassen. Eine weitere Abwandlung des Verfahrens sieht vor, die Schutzheiztemperatur stark abzusenken bis zu unbeheizt und die inaktiven Zeiten des Sensors zu nutzen, um mit 1V die Elektroden 16, 18 zu beschalten und anhand des dadurch fließenden Stroms Feuchtigkeit im Abgastrakt zu bestimmen und diese Zusatzinformation dem Motorsteuergerät zur Verfügung zu stellen, bzw. Taupunktende durch Messung zu bestimmen und nicht auf Modelle angewiesen zu sein.

## Patentansprüche

1. Verfahren zum Betreiben eines Sensors (10) zur Detektion von Teilchen, insbesondere von Rußpartikeln, in einem Messgas, insbesondere im Abgas einer Brennkraftmaschine, wobei der Sensor (10) ein Sensorelement (12) umfasst, wobei das Sensorelement (12) mindestens ein elektrisch isolierendes Element (14), eine erste Elektrode (16) und eine zweite Elektrode (18) aufweist, wobei die erste Elektrode (16) und die zweite Elektrode (18) an dem elektrisch isolierenden Element (14) angeordnet sind, wobei die erste Elektrode (16) und die zweite Elektrode (18) eine Strom- und/oder Spannungsmessung durchführen, wobei der Sensor (10) in mindestens einer Messphase betrieben wird, wobei während der Messphase an die erste Elektrode (16) und die zweite Elektrode (18) eine erste elektrische Spannung angelegt wird, wobei während eines vorbestimmten Zeitraums außerhalb der Messphase an die erste Elektrode (16) und die zweite Elektrode (18) eine zweite elektrische Spannung angelegt wird, ist; wobei auf das Vorhandensein von Wasser auf dem Sensorelement (12) geschlossen wird, falls die Strom- und/oder Spannungsmessung bei angelegter zweiter elektrischer Spannung einen Wert ergibt, der einen Schwellwert für einen elektrischen Strom überschreitet, **dadurch gekennzeichnet, dass** die zweite elektrische Spannung kleiner ist als eine Zersetzungsspannung für Wasser, welche 1,23 V beträgt.

2. Verfahren nach Anspruch 1, wobei eine Regeneration des Sensors (10) oder ein Wechsel in die Messphase verhindert wird, falls die Strom- und/oder Spannungsmessung bei angelegter zweiter elektrischer Spannung einen Wert ergibt, der einen ersten Schwellwert für einen elektrischen Strom überschreitet.

3. Verfahren nach Anspruch 2, wobei eine Regeneration des Sensors (10) oder ein Wechsel in die Messphase freigegeben wird, falls der Wert der Strom- und/oder Spannungsmessung nach dem Überschreiten des ersten Schwellwerts einen zweiten Schwellwert für einen elektrischen Strom unterschreitet.

4. Verfahren nach Anspruch 3, wobei eine Regeneration des Sensors (10) oder ein Wechsel in die Messphase nach einer vorbestimmten Zeit nach einem Unterschreiten des zweiten Schwellwerts freigegeben wird.

5. Verfahren nach einem der Ansprüche 2 bis 4, wobei eine Regeneration des Sensors (10) oder ein Wechsel in die Messphase freigegeben wird, falls der Sensor (10) von extern, bevorzugt einem Steuergerät (26), eine Taupunktendefreigabe erhält.

6. Verfahren nach einem der Ansprüche 1 bis 5, wobei der Sensor (10) während des vorbestimmten Zeitraums außerhalb der Messphase beheizt wird.

7. Verfahren nach Anspruch 6, wobei der Sensor (10) auf eine Temperatur beheizt wird, deren Höhe von dem Wert der Strom- und/oder Spannungsmessung bei angelegter zweiter elektrischer Spannung abhängt.

8. Verfahren nach einem der Ansprüche 1 bis 7, wobei der Sensor (10) in einem Abgastrakt einer Brennkraftmaschine angeordnet ist, wobei der vorbestimmte Zeitraum außerhalb der Messphase nach einem Kaltstart der Brennkraftmaschine, bei fehlender Taupunktendefreigabe durch ein Motorsteuergerät der Brennkraftmaschine und/oder bei Unterschreiten einer vorbestimmten Temperatur im Abgastrakt ist.

9. Verfahren nach einem der Ansprüche 1 bis 8, wobei die zweite elektrische Spannung einen Wert in einem Bereich von 0,005 V bis 1,2 V und bevorzugt 0,05 V bis 1,0 V ist.

10. Computerprogramm, umfassend Befehle, welche bewirken, dass ein mit einem Sensor zur Detektion von Partikeln verbundenes elektronisches Steuergerät jeden Schritt des Verfahrens nach einem der Ansprüche 1 bis 9 durchführt.

11. Elektronisches Speichermedium (28), auf welchem ein Computerprogramm nach Anspruch 10 gespeichert ist.

12. Elektronisches Steuergerät (26), welches ein elektronisches Speichermedium (28) nach Anspruch 11 umfasst.

## Claims

1. Method for operating a sensor (10) for detecting particles, in particular soot particles, in a measurement gas, in particular in the exhaust gas of an internal combustion engine, wherein the sensor (10) comprises a sensor element (12), wherein the sensor element (12) has at least one electrically insulating element (14), a first electrode (16) and a second electrode (18), wherein the first electrode (16) and the second electrode (18) are arranged on the electrically insulating element (14), wherein the first electrode (16) and the second electrode (18) carry out a current and/or voltage measurement, wherein the sensor (10) is operated in at least one measurement phase, wherein a first electrical voltage is applied to the first electrode (16) and the second electrode (18) during the measurement phase, wherein a second electrical voltage is applied to the first electrode (16) and the second electrode (18) during a predetermined period outside the measurement phase, wherein the presence of water on the sensor element (12) is inferred if the current and/or voltage measurement, when the second electrical voltage is applied, produces a value that exceeds a threshold value for an electrical current, **characterized in that** the second electrical voltage is less than a decomposition voltage for water, which is 1.23 V.

2. Method according to Claim 1, wherein a regeneration of the sensor (10) or a change into the measurement phase is prevented if the current and/or voltage measurement, when the second electrical voltage is applied, produces a value that exceeds a first threshold value for an electrical current.

3. Method according to Claim 2, wherein a regeneration of the sensor (10) or a change into the measurement phase is enabled if the value of the current and/or voltage measurement, after exceeding the first threshold value, undershoots a second threshold value for an electrical current.

4. Method according to Claim 3, wherein a regeneration of the sensor (10) or a change into the measurement phase is enabled after a predetermined time after the second threshold value has been undershot.

5. Method according to one of Claims 2 to 4, wherein a regeneration of the sensor (10) or a change into the measurement phase is enabled if the sensor (10) receives a dew point end release from the outside, preferably a control unit (26).

6. Method according to one of Claims 1 to 5, wherein the sensor (10) is heated during the predetermined period outside the measurement phase.

7. Method according to Claim 6, wherein the sensor (10) is heated to a temperature, the level of which depends on the value of the current and/or voltage measurement when the second electrical voltage is applied.

8. Method according to one of Claims 1 to 7, wherein the sensor (10) is arranged in an exhaust gas tract of an internal combustion engine, wherein the predetermined period outside the measurement phase is after a cold start of the internal combustion engine, in the absence of a dew point end release, by an engine control unit of the internal combustion engine and/or when a predetermined temperature in the exhaust gas tract is undershot.

9. Method according to one of Claims 1 to 8, wherein the second electrical voltage is a value in a range of 0.005 V to 1.2 V and preferably 0.05 V to 1.0 V.

10. Computer program comprising instructions which cause an electronic control unit connected to a sensor for detecting particles to carry out each step of the method according to one of Claims 1 to 9.

11. Electronic storage medium (28) on which a computer program according to Claim 10 is stored.

12. Electronic control unit (26) which comprises an electronic storage medium (28) according to Claim 11.

## Revendications

1. Procédé pour faire fonctionner un capteur (10) servant à la détection de particules, notamment de particules de suie, dans un gaz de mesure, notamment dans les gaz d'échappement d'un moteur à combustion interne, le capteur (10) comprenant un élément capteur (12), l'élément capteur (12) possédant au moins un élément électriquement isolant (14), une première électrode (16) et une deuxième électrode (18), la première électrode (16) et la deuxième électrode (18) étant disposées sur l'élément électriquement isolant (14), la première électrode (16) et la deuxième électrode (18) effectuant une mesure de courant et/ou de tension, le capteur (10) étant utilisé dans au moins une phase de mesure, une première tension électrique étant appliquée à la première électrode (16) et à la deuxième électrode (18) pendant la phase de mesure, une deuxième tension électrique étant appliquée à la première électrode (16) et à la deuxième électrode (18) pendant une période prédéterminée en dehors de la phase de mesure, la présence d'eau sur l'élément capteur (12) étant déduite si la mesure de courant et/ou de tension lorsque la deuxième tension est appliquée produit une valeur qui dépasse une valeur seuil pour un courant électrique, **caractérisé en ce que** la deuxième tension électrique est inférieure à une tension de décomposition de l'eau, qui est de 1,23 V.

2. Procédé selon la revendication 1, dans lequel une régénération du capteur (10) ou un passage à la phase de mesure est empêché si la mesure de courant et/ou de tension lorsque la seconde tension est appliquée produit une valeur qui dépasse une première valeur seuil pour un courant électrique.

3. Procédé selon la revendication 2, dans lequel une régénération du capteur (10) ou un passage à la phase de mesure est autorisé si la valeur de la mesure de courant et/ou de tension, après avoir dépassé la première valeur seuil, s'abaisse en dessous d'une deuxième valeur seuil pour un courant électrique.

4. Procédé selon la revendication 3, dans lequel une régénération du capteur (10) ou un passage à la phase de mesure est autorisé après une durée prédéterminée suivant l'abaissement en dessous de la deuxième valeur seuil.

5. Procédé selon l'une des revendications 2 à 4, dans lequel une régénération du capteur (10) ou un passage à la phase de mesure est autorisé si le capteur (10) reçoit, de manière externe, de préférence depuis un appareil de commande (26), une autorisation de fin de point de rosée.

6. Procédé selon l'une des revendications 1 à 5, dans lequel le capteur (10) est chauffé pendant la période prédéterminée en dehors de la phase de mesure.

7. Procédé selon la revendication 6, dans lequel le capteur (10) est chauffé à une température dont la hauteur dépend de la valeur de la mesure de courant et/ou de tension lorsque la deuxième tension électrique est appliquée.

8. Procédé selon l'une des revendications 1 à 7, dans lequel le capteur (10) est disposé dans un conduit de gaz d'échappement d'un moteur à combustion interne, la période prédéterminée en dehors de la phase de mesure se situant après un démarrage à froid du moteur à combustion interne, en l'absence d'une autorisation de fin de point de rosée donnée par un appareil de commande de moteur du moteur à combustion interne et/ou lorsqu'une température prédéterminée s'abaisse dans le conduit de gaz d'échappement.

9. Procédé selon l'une des revendications 1 à 8, dans lequel la deuxième tension électrique a une valeur se situant dans la plage de 0,005 V à 1,2 V, de préférence de 0,05 V à 1,0 V.

10. Programme informatique, comprenant des instructions qui amènent un appareil de commande électronique relié à un capteur de détection de particules à exécuter chaque étape du procédé selon l'une des revendications 1 à 9.

11. Support de stockage électronique (28) sur lequel est stocké un programme informatique selon la revendication 10.

12. Appareil de commande électronique (26) qui comprend un support de stockage électronique (28) selon la revendication 11.
